# EUROPÄISCHE PATENTSCHRIFT

(11) **EP 3 512 737 B1**
(45) Veröffentlichungstag und Bekanntmachung des Hinweises auf die Patenterteilung: **24.11.2021**
(21) Anmeldenummer: 17777800.8
(22) Anmeldetag: 14.09.2017
(51) Int. Cl.: B60L 15/08, H03K 17/16, H02M 7/5387, H03K 17/14

(54) **VERFAHREN ZUM BETREIBEN EINES STROMRICHTERS SOWIE DANACH ARBEITENDER STROMRICHTER**
METHOD FOR OPERATING A CURRENT CONVERTER AND CURRENT CONVERTER OPERATING ACCORDING TO SAID METHOD
PROCÉDÉ POUR FAIRE FONCTIONNER UN CONVERTISSEUR ET CONVERTISSEUR FONCTIONNANT DE MANIÈRE CORRESPONDANTE

(30) Priorität: 14.09.2016 DE 102016217494
(43) Veröffentlichungstag der Anmeldung: 24.07.2019
(73) Patentinhaber: Valeo Siemens eAutomotive Germany GmbH, 91056 Erlangen (DE)
(72) Erfinder: GU, Qiong, 91052 Erlangen (DE); HOFFMANN, Holger, 91093 Heßdorf (DE); SLAVIK, Thomas, 90513 Zirndorf (DE)
(74) Vertreter: Dr. Gassner & Partner mbB
(86) Internationale Anmeldenummer: PCT/EP2017/073102
(87) Internationale Veröffentlichungsnummer: WO 2018/050732

(56) Entgegenhaltungen:
- EP-A1- 2 256 917
- EP-A1- 2 733 849
- DE-A1-102014 219 470
- JP-A- 2010 252 451
- US-A1- 2001 002 782
- US-A1- 2012 039 100
- US-A1- 2014 001 839
- US-A1- 2016 036 430

## Beschreibung

Die Erfindung betrifft ein Verfahren zum Betreiben eines Stromrichters. Sie betrifft weiter einen nach diesem Verfahren arbeitenden Stromrichter und eine elektrische Maschine mit einem solchen Stromrichter.

Elektrisch (elektromotorisch) angetriebene Kraftfahrzeuge, wie beispielsweise Elektro- oder Hybridfahrzeuge, weisen typischerweise elektrische oder elektromotorische Maschinen zum Antrieb einer oder beider Kraftfahrzeugachsen auf. Derartige elektromotorische Antriebsmaschinen umfassen in der Regel einen gesteuerten Synchron- oder Asynchronmotor als Elektromotor, welcher zur Versorgung mit elektrischer Energie an einen fahrzeuginternen Energiespeicher (Hochvolt-Batterie) gekoppelt ist.

Der Elektromotor der elektrischen Maschine umfasst herkömmlicherweise einen gegenüber einem Stator drehbar gelagerten Rotor, welcher mittels eines magnetischen Drehfeldes angetrieben wird. Zur Erzeugung des Drehfeldes werden die Spulen (Phasenwicklungen, Statorwicklungen) des Stators mit einem entsprechenden Drehstrom (Wechselspannung) als Motorstrom beaufschlagt, welcher aus einer Gleichspannung beziehungsweise einem Gleichstrom (Eingangsstrom) des Energiespeichers mittels eines Stromrichters gewandelt wird.

Derartige Stromrichter sind einerseits dafür geeignet und eingerichtet, als Wechselrichter (Inverter) in einem Normalbetrieb der Maschine den Eingangsstrom des Energiespeichers in den Motorstrom zu wandeln. Andererseits sind die Stromrichter in der Regel dazu geeignet und eingerichtet, in einem generatorischen oder rekuperativen Betrieb als Gleichrichter einen erzeugten Motorstrom des Elektromotors in einen Gleichstrom (Rückspeisestrom) zur Einspeisung in den Energiespeicher zu wandeln.

Zu diesem Zwecke weist der Stromrichter eine mit einem Zwischenkreiskondensator gekoppelte Brückenschaltung auf (Zwischenkreis, Kommutierungskreis). Die Brückenschaltung umfasst eine Anzahl der (Motor-)Phasen entsprechende Anzahl von Brückenmodulen (Halbbrücken, Leistungsmodul, Kommutierungszelle) mit Halbleiterschaltern, die zwischen einer Hinleitung und einer Rückleitung des Stromrichters verschaltet sind.

Zur Ansteuerung der Halbleiterschalter der Brückenmodule sind in der Regel Treiberschaltungen vorgesehen, welche in Abhängigkeit von Signalen eines Controllers (Motorsteuerung) pulsweitenmodulierte Steuersignale (PWM-Signale) erzeugen. Die Steuersignale werden an einen Steueranschluss des jeweiligen Halbleiterschalters geführt, welcher somit getaktet zwischen einem leitenden (angeschalteten) Zustand und einem nichtleitenden (abgeschalteten, sperrenden) Zustand umgeschaltet wird. Im Betrieb werden die beispielsweise als IGBTs (insulated gate bipolar transistor) ausgeführten Halbleiterschalter über ihren jeweiligen Gateanschluss mit den Steuersignalen getaktet umgeschaltet, wodurch in der Folge der zu schaltende Kollektor- oder Laststrom in den Drehstrom für den Antrieb des Rotors gewandelt wird.

Die elektrische Verlustleistung eines solchen Stromrichters ist im Wesentlichen durch Durchlass- und Schaltverluste der Brückenmodule beziehungsweise deren Halbleiterschalter bestimmt. Hierbei weist das durch die Steuersignale charakterisierte (Gate-)Ansteuerverfahren einen wesentlichen Einfluss auf die Höhe der auftretenden Verlustleistungen - und somit auf den Wirkungsgrad - des Stromrichters auf. In der Regel weisen die Halbleiterschalter eine vergleichsweise langsame Abschaltgeschwindigkeit, das bedeutet eine lange (Abschalt-) Dauer bei einem Abschaltvorgang von dem leitenden in den nichtleitenden Zustand, auf. Dies bewirkt im Betrieb einen ungewünscht hohen Anteil an elektrischen Verlusten während der (Um-)Schaltvorgänge der Halbleiterschalter.

Bei einem derartigen Abschaltvorgang wird der zu schaltende Kollektor- beziehungsweise Laststrom, welcher im leitenden Zustand durch den Halbleiterschalter fließt, verringert, bis er im Wesentlichen abgeschaltet ist. Die Abschaltgeschwindigkeit ist hierbei im Wesentlichen durch die Steilheit der dadurch erzeugten Stromflanke des Laststroms definiert, mit welcher die Dauer des Abschaltvorgangs bestimmt ist. Diese Abschaltgeschwindigkeit ist mittels des Steuersignals zur (Gate-)Ansteuerung der Halbleiterschalter einstellbar beziehungsweise steuerbar und/oder regelbar.

Die US 2014/001839 A1 offenbart einen Stromrichter, umfassend: eine Ausgangsschaltung mit Schalteinrichtungen, eine Steuerschaltung, die dazu eingerichtet ist, den Schalteinrichtungen Steuersignale, um diese ein- und auszuschalten, bereitzustellen, einen Temperatursensor, der zum Erfassen einer Temperatur einer jeweiligen Schalteinrichtung eingerichtet ist, einen Spannungssensor, der zum Erfassen einer von einer Gleichspannungsquelle bereitgestellten Eingangsspannung eingerichtet ist, und einen Stromsensor, der zum Erfassen eines durch die Schalteinrichtungen fließenden Stroms eingerichtet ist. Die Steuerschaltung gibt den Schalteinrichtungen eine Schaltgeschwindigkeit aus zwei oder mehr Schaltgeschwindigkeiten vor. Eine Ermittlungsschaltung umfasst drei Komparatoren. Ein Komparator vergleicht ein Temperatursignal des Temperatursensors und eine Referenzspannung, welche einer Schwellwerttemperatur entspricht. Ein Komparator vergleicht ein Eingangsspannungssignal, das die Eingangsspannung beschreibt, und eine vorgegebene Referenzspannung. Ein Komparator vergleicht ein Stromsignal, das den Strom durch die Schalteinrichtungen beschreibt, und eine Referenzspannung, die einem vorgegebenen Referenzstrom entspricht. Eine Logikschaltung wendet eine vorgegebene logische Operation auf Ausgangssignale der Komparatoren an, wobei in Abhängigkeit eines von der Logikschaltung ausgegebenen Logiksignals eine schnellere oder eine langsamere Schaltgeschwindigkeit vorgegeben wird.

Die JP 2010 252451 A offenbart eine Schaltelementtreiberschaltung für eine Stromrichtereinrichtung, wobei ein Temperatursensor zur Bestimmung einer Schaltgeschwindigkeit des Halbleiterschalters vorgesehen ist.

Die US 2001/0002782 A1 offenbart ein Steuergerät für ein Fahrzeug mit einem Wechselrichter, der Leistungselemente umfasst. Das Steuergerät umfasst eine Eingangswiderstandvorgabeeinrichtung zum Vorgeben von Widerstandswerten von Eingangswiderständen der Leistungselemente in Abhängigkeit einer Spannung einer Speichereinrichtung für Gleichspannung und einer Temperatur der Leistungselemente.

Die EP 2 733 849 A1 offenbart eine Schaltungsvorrichtung mit einer Energiequelle, einem Zwischenkreis, einem IGBT, der über den Zwischenkreis an die Energiequelle gekoppelt ist, einer Steuereinrichtung zum Abschalten des IGBT mit einer Abschaltgeschwindigkeit und einer Erfassungseinrichtung zum Erfassen einer Spannung in dem Zwischenkreis, wobei die Steuereinrichtung zum Steuern der Abschaltgeschwindigkeit in Abhängigkeit von der Spannung ausgebildet ist.

Die US 2016/036420 A1 offenbart ein Verfahren zur Kalibrierung eines Versatzes zwischen einem Daten- und einem Taktsignal.

Die US 2012/039100 A1 offenbart eine in einem Fahrzeug eingebaute Stromrichtereinrichtung mit einer Widerstandsänderungseinheit zum Ändern eines Widerstandswerts eines Gatewiderstands eines Schaltelements. Es wird zwischen einem ersten Gatewiderstand und einem zweiten Gatewiderstand mit einem größeren Widerstandswert gewählt.

In der DE 10 2014 219 470 A1 ist ein Verfahren zur temperaturabhängigen Auswahl von Abschaltgeschwindigkeiten für Abschaltvorgänge in Halbleiterschaltern beschrieben. Dort sind die Halbleiterschalter an einem Gleichspannungszwischenkreis eines Umrichters angeordnet. Im Betrieb wird einerseits eine Gleichspannung des Gleichspannungszwischenkreises erfasst und mit einer Referenzgleichspannung verglichen. Andererseits wird eine Temperatur, insbesondere eine Sperrschichttemperatur, der Halbleiterschalter erfasst und mit einer Referenztemperatur verglichen. In Abhängigkeit der Vergleiche wird eine Abschaltgeschwindigkeit für die Halbleiterschalter eingestellt. Dadurch sollen für spezifische Arbeits- oder Betriebspunkte des Umrichters schnellere Abschaltgeschwindigkeiten der Halbleiterschalter möglich sein.

Der Erfindung liegt die Aufgabe zugrunde, ein besonders geeignetes Verfahren zum Betreiben eines Stromrichters anzugeben. Der Erfindung liegt weiterhin die Aufgabe zugrunde, einen nach einem derartigen Verfahren betriebenen Stromrichter sowie eine einen solchen Stromrichter aufweisende elektrischen Maschine anzugeben.

Hinsichtlich des Verfahrens wird die Aufgabe mit den Merkmalen des Anspruchs 1 und hinsichtlich des Stromrichters mit den Merkmalen des Anspruchs 3 sowie hinsichtlich der elektrischen Maschine mit den Merkmalen des Anspruchs 6 erfindungsgemäß gelöst. Vorteilhafte Ausgestaltungen und Weiterbildungen sind Gegenstand der jeweiligen Unteransprüche.

Das erfindungsgemäße Verfahren ist zum Betreiben eines Stromrichters geeignet und eingerichtet. Der Stromrichter ist insbesondere Teil einer elektrischen Maschine und als solcher beispielsweise als Wechselrichter zwischen einer Gleichstromquelle und einem Elektromotor verschaltet. Der Stromrichter weist hierbei mindestens einen Halbleiterschalter auf, welcher zweckmäßigerweise an einen Zwischenkreis der Maschine gekoppelt ist. Zur Ansteuerung des jeweiligen Halbleiterschalters wird ein Steuersignal zur Einstellung einer Abschaltgeschwindigkeit erzeugt und an einen Steueranschluss (Steuereingang) des Halbleiterschalters geführt.

Im Betrieb wird der Stromrichter in einem Arbeitsbereich betrieben. Dieser Arbeitsbereich ist charakterisiert durch die minimal und maximal zulässigen Betriebsparameter der Halbleiterschalter, bei welchen ein zuverlässiger und fehlerfreier Betrieb gewährleistet ist. Die Betriebsparameter umfassen im Wesentlichen einen minimalen und maximalen Spannungswert für die elektrische Zwischenkreisspannung (Gleichspannung) des Zwischenkreises und einen minimalen und maximalen Temperaturwert für eine Betriebstemperatur des jeweiligen Halbleiterschalters sowie einen minimalen und maximalen Stromwert für den durch den mittels des jeweiligen Halbleiterschalters geschalteten Laststrom.

Im Betrieb des Stromrichters werden die Betriebsparameter kontinuierlich überwacht. Hierbei wird einerseits die elektrische Zwischenkreisspannung des Zwischenkreises erfasst und mit einem Spannungsschwellwert verglichen. Andererseits wird die Betriebstemperatur des jeweiligen Halbleiterschalters erfasst und mit einem Temperaturschwellwert verglichen. Des Weiteren wird der mittels des jeweiligen Halbleiterschalters geschaltete Laststrom erfasst und mit einem Stromschwellwert verglichen.

Verfahrensgemäß wird hierbei das Steuersignal zur Einstellung der Abschaltgeschwindigkeit in Abhängigkeit der drei Vergleiche erzeugt. Dies bedeutet, dass zusätzlich zur zwischenkreisspannungs- und temperaturabhängigen Einstellung der Abschaltgeschwindigkeit zusätzlich der zu schaltende Laststrom berücksichtigt wird. Mit anderen Worten wird zusätzlich zu der Zwischenkreisspannung und der Betriebstemperatur die aktuell anliegende Last bei der Einstellung der Abschaltgeschwindigkeit berücksichtigt.

Durch die Schwellwerte wird der Arbeitsbereich des Stromrichters in unterschiedliche Betriebspunkte und/oder Betriebsbereiche aufgeteilt, welche beispielsweise jeweils eine zugeordnete Abschaltgeschwindigkeit aufweisen. Zweckmäßigerweise sind die jeweiligen Schwellwerte der Betriebsparameter größer als die minimal zulässigen Betriebsparameterwerte und kleiner als die maximal zulässigen Betriebsparameterwerte. Dadurch ist eine besonders flexible Anpassung an unterschiedliche Betriebssituationen des Stromrichters möglich, wodurch dessen Wirkungsgrad vorteilhaft erhöht wird. Insbesondere ist es dadurch beispielsweise möglich, bei einer gegebenen Abschaltgeschwindigkeit im Falle einer Veränderung des Betriebspunkts eine Ausnutzung der spezifizierten Maximalspannung zu erreichen.

Die Halbleiterschalter sind vorzugsweise als IGBTs ausgeführt, wobei die erfasste Zwischenkreisspannung ein Maß für die im Betrieb anliegende Kollektor-Emitter-Spannung ist, und wobei die Betriebstemperatur insbesondere den Temperaturwert einer Sperrschichttemperatur des Halbleiterschalters beschreibt.

Durch das Verfahren ist somit eine besonders einfache und aufwandsarme Anpassung an einen jeweiligen, anwendungsspezifischen Hauptbetriebsbereich des Stromrichters oder der damit ausgestatteten elektrischen Maschine möglich. Insbesondere wird die Abschaltgeschwindigkeit nicht lediglich anhand von maximalen Grenzen (beispielsweise maximaler Laststrom und maximale Zwischenkreisspannung) eingestellt, sondern in Abhängigkeit des gewünschten Hauptbetriebsbereichs. Dies bedeutet, dass die Einstellung der Abschaltgeschwindigkeit für einen spezifischen Betriebsbereich oder Betriebspunkt des Halbleiterschalters feingranularer beziehungsweise hoch aufgelöster gestaltbar ist, wodurch elektrische Verluste bei einem Abschaltvorgang zielgerichtet und anwendungsorientiert reduzierbar sind.

Insbesondere in einer Anwendung, in welcher baugleiche Stromrichter in unterschiedlichen elektrischen Maschinen, beispielsweise in unterschiedlichen elektrisch betriebenen Kraftfahrzeugen, eingesetzt werden, ist durch das Verfahren sichergestellt, dass die Stromrichter an den jeweiligen Hauptbetriebsbereich, das bedeutet dem im Betrieb am häufigsten auftretenden Betriebsbereich der jeweiligen Maschine, optimal anpassbar sind. Der Hauptbetriebsbereich variiert für unterschiedliche Maschinen, wobei durch das Verfahren stets ein besonders hoher Wirkungsgrad gewährleistet wird. Des Weiteren ist hierdurch eine kostenintensive Überdimensionierung der Halbleiterschalter und/oder weiterer Bauteile des Stromrichters vorteilhaft vermeidbar.

Erfindungsgemäß wird das Steuersignal zur Einstellung der Abschaltgeschwindigkeit in Abhängigkeit der Vergleiche aus drei hinterlegten Abschaltgeschwindigkeiten ausgewählt. Die erste Abschaltgeschwindigkeit ist hierbei langsamer als die zweite Abschaltgeschwindigkeit, wobei die zweite Abschaltgeschwindigkeit langsamer als die dritte Abschaltgeschwindigkeit ist.

Mit anderen Worten, wird durch die erste Abschaltgeschwindigkeit eine vergleichsweise lange Dauer des Abschaltvorgangs, das bedeutet einen vergleichsweise langsamen Abschaltprozess mit einer vergleichsweise flachen Stromflankensteilheit des Laststroms, bewirkt. Die zweite Abschaltgeschwindigkeit bewirkt entsprechend einen vergleichsweise schnellen Abschaltprozess mit einer steileren Stromflankensteilheit und die dritte Abschaltgeschwindigkeit einen besonders schnellen Abschaltprozess mit einer besonders steilen Stromflankensteilheit. Dadurch sind im Wesentlichen drei Betriebsbereiche des Stromrichters definiert, wodurch ein besonders einfacher und aufwandsarmer Betrieb mit gleichzeitig möglichst hoher Flexibilität ermöglicht ist.

Erfindungsgemäß wird das Steuersignal auf die erste Abschaltgeschwindigkeit eingestellt, wenn die erfasste Betriebstemperatur kleiner als der Temperaturschwellwert ist, und/oder wenn die Zwischenkreisspannung größer als der Spannungsschwellwert ist. Durch die vergleichsweise langsame erste Abschaltgeschwindigkeit werden für die in einem Grenzbereich des zugelassenen Arbeitsbereichs der Halbleiterschalter liegenden Betriebspunkte ein zuverlässiger und betriebssicherer Abschaltvorgang gewährleistet.

Erfindungsgemäß wird das Steuersignal auf die zweite Abschaltgeschwindigkeit eingestellt, wenn die Betriebstemperatur größer als der Temperaturschwellwert ist, und wenn der Laststrom größer als der Stromschwellwert ist. Dadurch wird über einen vergleichsweise breiten Spannungsbereich eine vergleichsweise schnelle Abschaltgeschwindigkeit, mit entsprechend reduzierter elektrischer Verlustleistung, realisiert.

Erfindungsgemäß wird das Steuersignal auf die dritte Abschaltgeschwindigkeit eingestellt, wenn die Betriebstemperatur größer als der Temperaturschwellwert ist, und wenn der Laststrom kleiner als der Stromschwellwert ist. Dadurch wird ein effektiver und effizienter Betrieb des Stromrichters gewährleistet.

Ein zusätzlicher oder weiterer Aspekt des erfindungsgemäßen Verfahrens sieht vor, dass der Stromschwellwert in Abhängigkeit der Zwischenkreisspannung eingestellt wird. Dadurch wird ein besonders effektiver und effizienter Betrieb des Stromrichters gewährleistet. Insbesondere ist der Verlauf des Stromschwellwertes hierbei an den gewünschten Hauptbetriebsbereich angepasst, sodass sich der Hauptbetriebsbereich vorzugsweise im Wesentlichen vollständig in dem mit der dritten Abschaltgeschwindigkeit arbeitenden Betriebsbereich befindet.

Der erfindungsgemäße Stromrichter ist insbesondere Teil einer elektrischen Maschine. Der Stromrichter umfasst eine mit dem Zwischenkreis gekoppelte Brückenschaltung. Die Brückenschaltung weist eine Anzahl von mittels Treiberschaltungen angesteuerten Halbleiterschaltern auf, wobei die Treiberschaltungen signaltechnisch an einen Controller (Steuereinheit) geführt sind. Der Controller ist hierbei allgemein - programm-und/oder schaltungstechnisch - zur Durchführung des vorstehend beschriebenen Verfahrens eingerichtet. Der Controller ist somit konkret dazu eingerichtet, während eines Betriebs des Stromrichters die (Ist-)Werte der Zwischenkreisspannung und der Betriebstemperatur sowie des Laststroms zu erfassen und/oder zu überwachen. Der Controller ist weiterhin dazu eingerichtet, die erfassten Werte mit den jeweiligen, hinterlegten Schwellwerten zu vergleichen, und in Abhängigkeit des Vergleichs die Treiberschaltungen zur Erzeugung des Steuersignals einzustellen.

In bevorzugter Ausgestaltung ist der Controller zumindest im Kern durch einen Mikrocontroller mit einem Prozessor und einem Datenspeicher gebildet, in dem die Funktionalität zur Durchführung des erfindungsgemäßen Verfahrens in Form einer Betriebssoftware (Firmware) programmtechnisch implementiert ist, so dass das Verfahren - gegebenenfalls in Interaktion mit einem (Fahrzeug-)Nutzer - bei Ausführung der Betriebssoftware in dem Mikrocontroller automatisch durchgeführt wird.

Der Controller kann im Rahmen der Erfindung alternativ aber auch durch ein nicht-programmierbares elektronisches Bauteil, z. B. einem ASIC (anwendungsspezifischer integrierter Schaltkreis), gebildet sein, in dem die Funktionalität zur Durchführung des erfindungsgemäßen Verfahrens mit schaltungstechnischen Mitteln implementiert ist.

Der mit dem Verfahren betriebene Stromrichter weist somit abhängig vom jeweiligen Betriebspunkt stets eine möglichst optimale Abschaltgeschwindigkeit der Halbleiterschalter auf.

In einer vorteilhaften Weiterbildung weisen die Treiberschaltungen eine der Anzahl der einstellbaren Abschaltgeschwindigkeiten entsprechende Anzahl von elektrischen Vorwiderständen (Abschaltwiderstand) auf. Dadurch ist in einfacher Art und Weise eine verlustoptimale Wahl der Abschaltgeschwindigkeit der Halbleiterschalter mittels einer Spannungs-Temperatur und Lastabhängigen Umschaltung zwischen den unterschiedlichen Vorwiderständen realisiert. Die (Gate-)Vorwiderstände weisen geeigneterweise unterschiedliche (ohmsche) Widerstandswerte auf, sodass bei einem Umschalten die Amplitude des Steuersignals variiert wird. Durch die veränderte Amplitude wird in der Folge der Halbleiterschalter mit einer veränderten Abschaltgeschwindigkeit abgeschaltet.

In einer zweckmäßigen Ausbildung sind die Vorwiderstände der Treiberschaltungen parallel zueinander geschaltet. Der Controller steuert hierbei eine jeweilige Ansteuerschaltung der Treiberschaltungen zum Um- oder Zuschalten der Vorwiderstände an. Dadurch wird stets der optimale Gatevorwiderstand abhängig vom jeweiligen Betriebspunkt eingestellt. Dadurch ist eine hardwarebasierte Erzeugung der verschiedenen Abschaltgeschwindigkeiten realisiert.

In einer alternativen Ausbildungsform ist es zur Einstellung der Abschaltgeschwindigkeit beispielsweise ebenso denkbar, dass das Steuersignal mittels eines Active-Clampings oder mittels einer Stromsteuerung eingestellt wird.

In einer bevorzugten Anwendung wird der nach dem Verfahren betriebene Stromrichter in einer elektrischen Maschine, insbesondere für ein elektrisch betriebenes Kraftfahrzeug (Elektrofahrzeug, Hybridfahrzeug), eingesetzt. Hierzu ist der Stromrichter beispielsweise als Wechselrichter zwischen einem fahrzeuginternen Energiespeicher und einem Elektromotor geschaltet. Durch das Verfahren wird ein effektiver und sicherer Betrieb der Halbleiterschalter gewährleistet, wobei die elektrischen Verluste in den Halbleiterschaltern reduziert werden. Dadurch ist eine elektrische Maschine mit einem besonders hohen Wirkungsgrad bereitgestellt, welcher einen besonders betriebswirtschaftlichen Betrieb des Kraftfahrzeugs ermöglicht. Dies überträgt sich in der Folge vorteilhaft auf die wirtschaftlichen Anforderungen bei der Herstellung des Kraftfahrzeugs sowie auf einen kostengünstigen und effektiven Betrieb des Kraftfahrzeugs.

Nachfolgend werden Ausführungsbeispiele der Erfindung anhand einer Zeichnung näher erläutert. Darin zeigen in vereinfachten und schematischen Darstellungen:
- FIG 1: eine elektrische Maschine mit einem Energiespeicher und mit einem Elektromotor sowie mit einem dazwischen geschalteten Stromrichter,
- FIG 2: ausschnittsweise ein Brückenmodul des Stromrichters mit einem Halbleiterschalter und eine damit gekoppelte Treiberschaltung,
- FIG 3: ein Diagramm eines Verfahrens zur Auswahl einer Abschaltgeschwindigkeit für ein von der Treiberschaltung erzeugtes Steuersignal,
- FIG 4: ein Diagramm des Arbeitsbereichs des Stromrichters mit drei Betriebsbereichen mit unterschiedlichen Abschaltgeschwindigkeiten, und
- FIG 5: ein Diagramm eines Arbeitsbereichs mit drei angepassten Betriebsbereichen für einen hoch effektiven Betrieb des Stromrichters.

Einander entsprechende Teile und Größen sind in allen Figuren stets mit den gleichen Bezugszeichen versehen.

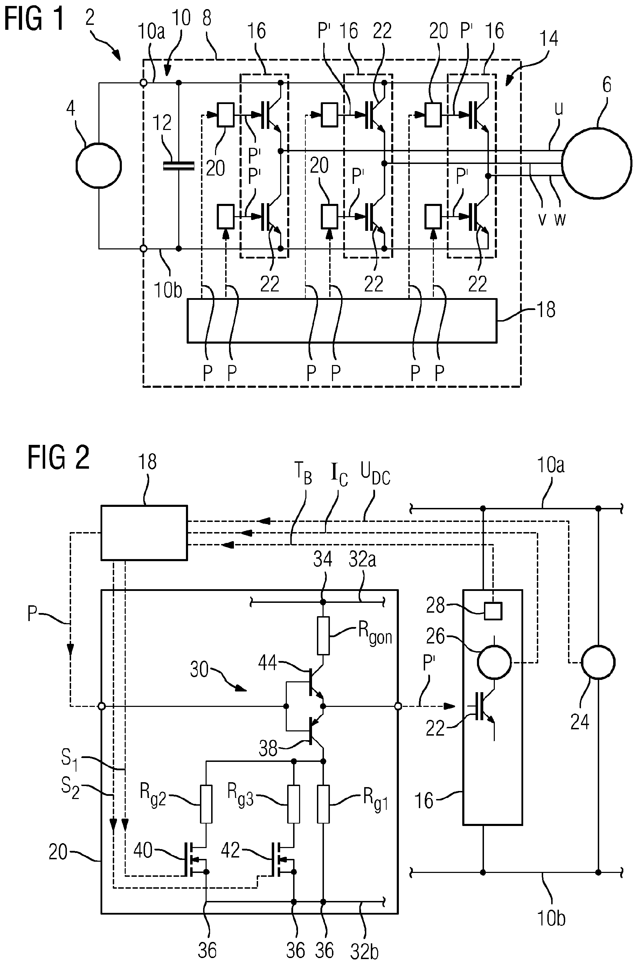

In der FIG 1 ist eine elektrische (Antriebs-)Maschine 2 eines nicht näher dargestellten, elektromotorisch angetriebenen Kraftfahrzeugs, insbesondere eines Elektro- oder Hybridfahrzeugs, gezeigt. Die Maschine 2 umfasst in diesem Ausführungsbeispiel einen fahrzeuginternen, elektrischen Energiespeicher 4 in Form einer Hochvolt-Batterie und einen die Kraftfahrzeugachsen antreibenden Elektromotor 6. Der beispielsweise als Synchron- oder Asynchronmotor ausgeführte Elektromotor 6 ist hierbei mittels eines als Wechselrichter ausgeführten Stromrichters 8 an den Energiespeicher 4 angeschlossen.

Der Stromrichter 8 weist eine Hinleitung 10a und eine Rückleitung 10b auf. Die Hinleitung 10a und die Rückleitung 10b sind Teil eines Zwischenkreises 10, mit welchem der Stromrichter 8 an den Energiespeicher 4 angeschlossen ist. Zwischen den Leitungen 10a und 10b ist ein Zwischenkreiskondensator 12 sowie eine Brückenschaltung 14 mit drei Brückenmodulen (Halbbrücken, Kommutierungszellen) 16 geschaltet.

Im Betrieb wird ein dem Stromrichter 8 zugeführter Eingangsstrom des Energiespeichers 4 durch die Brückenschaltung 14 in eine dreiphasige Motorspannung beziehungsweise einen Drehstrom mit den Phasen u, v, w gewandelt. Die Phasen u, v, w - nachfolgend auch zusammenfassend als Motorstrom bezeichnet - werden zum Betrieb des Elektromotors 6 an entsprechende Phasen- oder Wicklungsenden eines nicht näher dargestellten Stators geführt.

Zur Wandlung des aus der Hochvolt-Gleichspannung des Energiespeichers 4 gestellten Eingangsstroms in den Motorstrom, werden die Brückenmodule 16 mittels eines an eine Motorsteuerung angeschlossenen Controllers 18 gesteuert und/oder geregelt. Zu diesem Zwecke sendet der Controller 18 jeweils ein PWM-Signal P (pulsweitenmoduliert) an eine von sechs Treiberschaltungen 20. Jedes Brückenmodul 16 weist hierbei zwei als IGBTs (insulated gate bipolar transistor) ausgeführte Halbleiterschalter 22 auf, deren jeweiliger Steueranschluss (Gateanschluss) an den Ausgang der jeweils zugeordneten Treiberschaltung 20 geführt ist. In einer möglichen alternativen Ausführung sind die Treiberschaltungen 20 beispielsweise Teil des jeweiligen Brückenmoduls 16. In der FIG 1 sind die Halbleiterschalter 22 und Treiberschaltungen 20 lediglich beispielhaft mit Bezugszeichen versehen.

Anhand der FIG 2 wird nachfolgend die Treiberschaltung 20 eines Halbleiterschalters 22 näher erläutert. In der FIG 2 ist lediglich ein Halbleiterschalter 22 des Brückenmoduls 16 beispielhaft dargestellt. Die dargestellte Treiberschaltung 20 ist dazu geeignet und eingerichtet den Halbleiterschalter 22 mit drei unterschiedlichen Abschaltgeschwindigkeiten A₁, A₂, A₃ abzuschalten, das bedeutet, von einem leitenden in einen sperrenden Zustand umzuschalten.

Wie in der FIG 2 dargestellt, ist zwischen dem positiven (Gleichspannungs-)Potential der Hinleitung 10a und dem negativen (Gleichspannungs-)Potential der Rückleitung 10b ein Spannungsmesser 24 zur Erfassung der zwischen den Leitungen 10a und 10b anliegenden Gleichspannung beziehungsweise Zwischenkreisspannung U_{dc} angeordnet. Das Brückenmodul 16 weist hierbei einen Temperaturmesser 26 zur Erfassung einer Betriebstemperatur T_{B}, insbesondere einer Sperrschichttemperatur, des Halbleiters 22 auf. Das Brückenmodul 16 umfasst weiterhin einen Strommesser 28, mit welchem ein durch den Halbleiterschalter 22 zu schaltender Kollektor- beziehungsweise Laststrom I_{c} erfasst wird.

Die erfassten Messsignale des Spannungsmessers 24 und des Temperaturmessers 26 sowie des Strommessers 28 sind signaltechnisch an eine Eingangsseite des Controllers 18 geführt. Der Controller 18 ist ausgangsseitig signaltechnisch an die Treiberschaltung 20 angebunden. Im Betrieb versendet der Controller 18 in Abhängigkeit der empfangenen Signale ein erstes Schaltsignal S₁ und ein zweites Schaltsignal S₂ sowie das getaktete PWM-Signal P an die Treiberschaltung 20. Die Treiberschaltung 20 erzeugt in Abhängigkeit der eingehenden Signale ein Steuersignal P', insbesondere zum Abschalten des Halbleiterschalters 22.

Die Treiberschaltung 20 weist eine Ansteuerschaltung 30 auf. Die Ansteuerschaltung 30 ist an einen Pluspfad 32a und einen Minuspfad 32b eines nicht näher dargestellten Gleichspannungskreises angeschlossen. Der Gleichspannungskreis ist galvanisch von dem Zwischenkreis 10 getrennt und wirkt als eine Spannungsversorgung für die Treiberschaltung 20. Zu diesem Zwecke ist die Ansteuerschaltung 20 mit einem ersten Anschluss 34 an den Pluspfad 32a und mit drei zweiten Anschlüssen 36 an den Minuspfad 32b angeschlossen.

Die Ansteuerschaltung 30 umfasst drei zueinander parallel geschaltete Vorwiderstände (Gate-Abschaltvorwiderstände) R_{g1}, R_{g2} und R_{g3}, welche einerseits jeweils an einen der Anschlüsse 36 sowie andererseits gemeinsam an einen Halbleiterschalter (Gate-Abschalthalbleiter) 38 geführt sind. Der Vorwiderstand R_{g2} ist mittels eines durch das Schaltsignal S₁ gesteuerten Halbleiterschalters 40 an den zugeordneten Anschluss 36 geführt. Der Vorwiderstand R_{g3} ist hierbei mittels eines durch das Schaltsignal S₂ gesteuerten Halbleiterschalters 42 an den zugeordneten Anschluss 36 geführt.

Der Halbleiterschalter 38 ist mit dem getakteten PWM-Signal P ansteuerbar und an den Steueranschluss des Halbleiterschalters 22 geführt. Die Ansteuerung des Halbleiterschalters 38 dient hierbei insbesondere dem Abschalten des Halbleiterschalters 22 mit einer Abschaltgeschwindigkeit A₁, A₂, A₃.

Der Anschluss 34 ist mittels eines Vorwiderstandes (Gate-Einschaltvorwiderstand) R_{gon} an einen Eingangsanschluss eines Halbleiterschalters (Gate-Einschalthalbleiter) 44 geführt. Mit dem Vorwiderstand R_{gon} ist eine Einschaltgeschwindigkeit während eines Einschaltens, das bedeutet dem Umschalten von einem sperrenden in einen leitenden Zustand, des Halbleiterschalters 22 vorgebbar.

Wie aus der FIG 2 vergleichsweise deutlich ersichtlich, ist der durch das getaktete PWM-Signal P ansteuerbare Halbleiterschalter 38 für die Abschaltvorgänge des Halbleiterschalters 22 als ein pnp-Transistor ausgelegt. Entsprechend ist der mittels des getakteten PWM-Signals P ansteuerbare Halbleiterschalter 44 für die Einschaltvorgänge des Halbleiterschalters 22 als ein npn-Transistor ausgeführt. Elektrisch ist somit sichergestellt, dass je nach Status (Schaltzustand) des PWM-Signals P entweder lediglich der Halbleiterschalter 38 für den Abschaltvorgang oder lediglich der Halbleiterschalter 44 für den Einschaltvorgang des Halbleiterschalters 22 durchgeschaltet wird.

Zur Erzeugung eines Steuersignals P', zum Abschalten des Halbleiterschalters 22 mit der ersten, vergleichsweise langsamen, Abschaltgeschwindigkeit A₁, werden die Halbleiterschalter 40 und 42 mittels der Schaltsignale S₁ und S₂ sperrend geschaltet. Dadurch ist der Halbleiterschalter 38 lediglich mittels des Vorwiderstandes R_{g1} an den Minuspfad 32b geführt.

Zum Abschalten des Halbleiterschalters 22 durch das Steuersignal P' mit der zweiten, vergleichsweise schnellen, Abschaltgeschwindigkeit A₂, wird der Halbleiterschalter 40 durch das Schaltsignal S₁ leitend, und der Halbleiterschalter 42 mittels des Schaltsignals S₂ sperrend geschaltet. Dadurch wirken die Vorwiderstände R_{g1} und R_{g2} als gemeinsamer Parallelwiderstand für den Halbleiterschalter 38.

Zur Erzeugung eines Steuersignals P' mit der dritten, vergleichsweise sehr schnellen, Abschaltgeschwindigkeit A₃, wird der Halbleiterschalter 40 durch das Schaltsignal S₁ sperrend, und der Halbleiterschalter 42 mittels des Schaltsignals S₂ leitend geschaltet. Dadurch wirken die Vorwiderstände R_{g1} und R_{g3} als gemeinsamer Parallelwiderstand für den Halbleiterschalter 38.

Das Steuersignal P' weist somit im Wesentlichen das gleiche Taktverhältnis (Tastgrad) des eingehenden PWM-Signals P auf, unterscheidet sich jedoch hinsichtlich dessen (Spannungs-) Amplitude. Die Vorwiderstände R_{g1}, R_{g2} und R_{g3} sind hierbei vorzugsweise derart dimensioniert, dass durch das Schalten der Halbleiterschalter 40 und 42 drei unterschiedliche Abschaltgeschwindigkeiten A₁, A₂ und A₃ für das Steuersignal P' einstellbar sind. Insbesondere sind die Vorwiderstände R_{g1}, R_{g2} und R_{g3} hierbei derart dimensioniert, dass die erste Abschaltgeschwindigkeit A₁ langsamer als die zweite Abschaltgeschwindigkeit A₂ und die zweite Abschaltgeschwindigkeit A₂ langsamer als die dritte Abschaltgeschwindigkeit A₃ ist.

Die Schaltsignale S₁ und S₂ werden von dem Controller 18 in Abhängigkeit von Schwellwertvergleichen der erfassten Werte der Zwischenkreisspannung U_{dc} und der Betriebstemperatur T_{B} sowie des Laststroms I_{c} mit entsprechend hinterlegten Schwellwerten erzeugt.

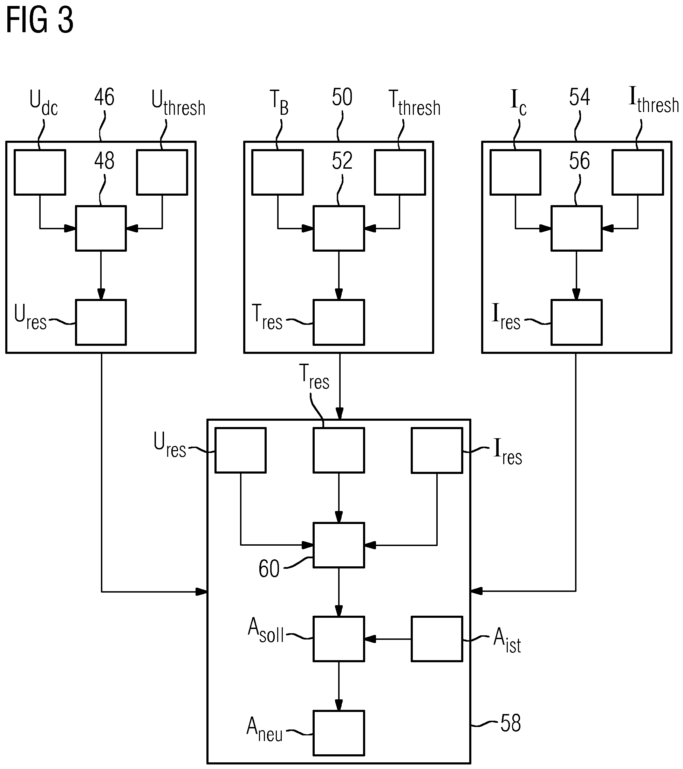

Nachfolgend wird anhand des schematischen Diagramms der FIG 3 ein Ausführungsbeispiel für ein in dem Controller 18 implementiertes Verfahren zur Auswahl und Einstellung einer Abschaltgeschwindigkeit Aₙₑᵤ - und somit der Erzeugung der Schaltsignale S₁ und S₂ - erläutert.

In einem ersten Verfahrensschritt 46 wird der erfasste Wert der Zwischenkreisspannung U_{dc} in einem Schwellwertvergleich 48 mit einem hinterlegten Spannungsschwellwert Uₜₕᵣₑₛₕ verglichen. Der Schwellwertvergleich 48 stellt in Abhängigkeit des Vergleichs ein Spannungsergebnis Uᵣₑₛ bereit.

In einem zweiten Verfahrensschritt 50 wird die erfasste Betriebstemperatur T_{B} in einem Schwellwertvergleich 52 mit einem hinterlegten Temperaturschwellwert Tₜₕᵣₑₛₕ verglichen. Der Schwellwertvergleich 52 stellt in Abhängigkeit des Vergleichs ein Temperaturergebnis Tᵣₑₛ bereit.

In einem dritten Verfahrensschritt 54 wird entsprechend ein Schwellwertvergleich 56 zwischen dem erfassten Laststrom I_{c} und einem hinterlegten Stromschwellwert Iₜₕᵣₑₛₕ durchgeführt. Der Schwellwertvergleich 56 erzeugt in Abhängigkeit des Vergleichs ein Stromergebnis Iᵣₑₛ.

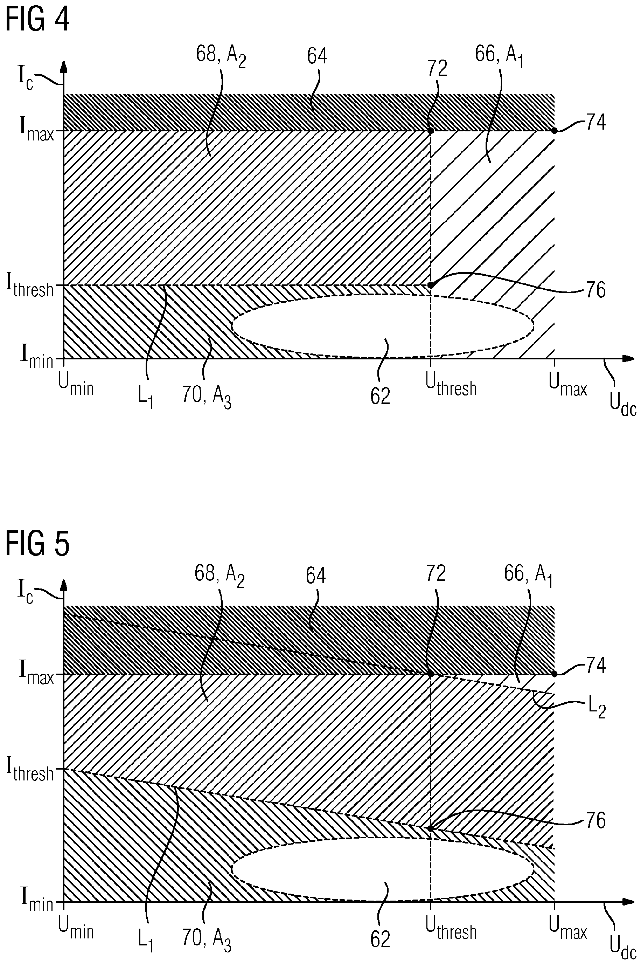

Die Vergleichsergebnisse Uᵣₑₛ, Tᵣₑₛ, Iᵣₑₛ werden anschließend in einem Verfahrensschritt 58 zur Einstellung der Abschaltgeschwindigkeit Aₙₑᵤ verwendet. Hierzu werden die Vergleichsergebnisse Ures, Tres, Ires in einem Schritt 60 miteinander kombiniert. Die Kombination der Vergleichsergebnisse Uᵣₑₛ, Tᵣₑₛ, Iᵣₑₛ im Schritt 60 entspricht im Wesentlichen der Bestimmung eines aktuellen Ist-Betriebspunkts des Stromrichters 8. Der Arbeitsbereich des Stromrichters 8 ist zweckmäßigerweise in unterschiedliche Betriebsbereiche unterteilt (FIG 4, FIG 5), wobei jedem Betriebsbereich eine jeweilige Abschaltgeschwindigkeit A₁, A₂, A₃ zugeordnet ist. Die Betriebsbereiche sind als Kombinationsergebnisse der Vergleichsergebnisse Uᵣₑₛ, Tᵣₑₛ, Iᵣₑₛ in dem Controller 18 hinterlegt. Mit anderen Worten ist es möglich, den bestimmten Ist-Betriebspunkt einem dieser Betriebsbereiche - und somit einer Soll-Abschaltgeschwindigkeit Aₛₒₗₗ - zuzuordnen.

Die Soll-Abschaltgeschwindigkeit Aₛₒₗₗ wird mit einer aktuellen Ist-Abschaltgeschwindigkeit Aᵢₛₜ verglichen, wobei bei einer Abweichung der Soll-Abschaltgeschwindigkeit Aₛₒₗₗ von der Ist-Abschaltgeschwindigkeit Aᵢₛₜ die Abschaltgeschwindigkeit Aₙₑᵤ auf den Wert der Soll-Abschaltgeschwindigkeit Aₛₒₗₗ eingestellt wird. Hierzu überprüft der Controller 18 beispielsweise die Ist- und Soll-Schaltzustände der Schaltsignale Si und S₂.

Zur Einstellung auf die neue Abschaltgeschwindigkeit Aₙₑᵤ steuert und/oder regelt der Controller 18 die Schaltsignale S₁ und S₂. Wird der Stromrichter 8 beispielsweise mit der ersten Abschaltgeschwindigkeit A₁ betrieben und festgestellt, dass der neu-erfasste Betriebspunkt in einem Betriebsbereich mit der Abschaltgeschwindigkeit A₂ liegt, so wird der Halbleiterschalter 40 durch das Schaltsignal S₁ von sperrend zu leitend und der Halbleiterschalter 42 mittels des Schaltsignals S₂ weiterhin sperrend geschaltet. Dadurch wird in der Folge ein Steuersignal P' erzeugt, mit welchem der Halbleiterschalter 22 mit der Abschaltgeschwindigkeit A₂ abgeschaltet wird.

In den Figuren 4 und 5 ist jeweils beispielhaft ein Arbeitsbereich des Stromrichters 8 dargestellt. Der Arbeitsbereich deckt hierbei im Wesentlichen alle im Betrieb relevanten Betriebspunkte des Stromrichters 8 ab. Der dargestellte Arbeitsbereich umfasst hierbei einen beispielhaft dargestellten Hauptbetriebsbereich 62 der elektrischen Maschine 2 sowie einen Bereich 64 in welchem kein fehlerfreier Betrieb des Stromrichters 8 möglich ist.

Die Abszissenachse (x-Achse) ist hierbei eine Spannungsachse für die im Zwischenkreis 10 anliegende Zwischenkreisspannung U_{dc}. Die zulässige Zwischenkreisspannung U_{dc} ist hierbei auf einen Spannungsbereich zwischen einer Minimalspannung Uₘᵢₙ und einer Maximalspannung Uₘₐₓ eingeschränkt. Entlang der Ordinatenachse (y-Achse) ist der Laststrom I_{c} aufgetragen, welcher im Betrieb auf einen Strombereich zwischen einem Minimalstrom Iₘᵢₙ und einem Maximalstrom Iₘₐₓ eingeschränkt ist. Oberhalb des Maximalstroms Iₘₐₓ erstreckt sich der Bereich 64. Ein Betriebspunkt des Stromrichters 8 wird hierbei durch ein Spannungs-Strom-Wertepaar (U_{dc}, I_{c}) charakterisiert.

Im Betrieb des Stromrichters 8 wird die erfasste Zwischenkreisspannung U_{dc} mit dem Spannungsschwellwert Uₜₕᵣₑₛₕ und die Betriebsspannung T_{B} mit dem Temperaturschwellwert Tₜₕᵣₑₛₕ sowie der Laststrom I_{c} mit dem Stromschwellwert Iₜₕᵣₑₛₕ verglichen. Der Spannungsschwellwert Uₜₕᵣₑₛₕ und der Stromschwellwert Iₜₕᵣₑₛₕ sind in den Figuren 4 und 5 als strichlinierte Linien in den dargestellten Arbeitsbereich eingezeichnet.

In der FIG 4 wird der dargestellte Arbeitsbereich durch den Spannungsschwellwert Uₜₕᵣₑₛₕ und den Stromschwellwert Iₜₕᵣₑₛₕ im Wesentlichen in drei Betriebsbereiche 66, 68 und 70 unterteilt, welchen jeweils durch eine Abschaltgeschwindigkeit A₁, A₂ und A₃ zugeordnet ist. Mit anderen Worten werden im Betrieb für alle Betriebspunkte eines jeweiligen Betriebsbereichs 66, 68, 70 Steuersignale P' mit der jeweils zugeordneten Abschaltgeschwindigkeit A₁, A₂, A₃ erzeugt. Der Stromschwellwert Iₜₕᵣₑₛₕ ist in diesem Ausführungsbeispiel spannungsunabhängig, das bedeutet, der Stromschwellwert Iₜₕᵣₑₛₕ weist für unterschiedliche Zwischenkreisspannungen U_{dc} im Wesentlichen stets den gleichen Wert auf.

Für die Betriebspunkte des Betriebsbereichs 66 wird das Steuersignal P' auf die ersten Abschaltgeschwindigkeit A₁ eingestellt. Der Betriebsbereich 66 erstreckt sich im Wesentlichen über den vollständigen Strombereich zwischen dem Minimalstrom Iₘᵢₙ und dem Maximalstrom Iₘₐₓ.

Der Betriebsbereich 66 ist hierbei zwischen einer Minimaltemperatur und dem Temperaturschwellwert Tₜₕᵣₑₛₕ beziehungsweise zwischen dem Spannungsschwellwert Uₜₕᵣₑₛₕ und der Maximalspannung Uₘₐₓ festgelegt. Mit anderen Worten wird ein Steuersignal P' mit der ersten Abschaltgeschwindigkeit A₁ erzeugt, wenn in dem Schritt 60 festgestellt wird, dass das Temperaturergebnis Tᵣₑₛ einer Betriebstemperatur T_{B} kleiner dem Temperaturschwellwert Tₜₕᵣₑₛₕ ist oder, dass das Spannungsergebnis Uᵣₑₛ einer Zwischenkreisspannung U_{dc} entspricht, welche größer (oder gleich) dem Spannungsschwellwert Uₜₕᵣₑₛₕ ist.

Der Betriebsbereich 66 weist zwei (Eck-)Betriebspunkte 72 und 74, für welche der Laststrom I_{c} gleich dem Maximalstrom Iₘₐₓ ist. In dem Betriebspunkt 72 ist die Zwischenkreisspannung U_{dc} gleich dem Spannungsschwellwert Uₜₕᵣₑₛₕ und die Betriebs-oder Sperrschichttemperatur T_{B} gleich dem Temperaturschwellwert Tₜₕᵣₑₛₕ. In dem dem Betriebspunkt 72 gegenüberliegenden Betriebspunkt 74 des Betriebsbereichs 66 ist die Zwischenkreisspannung U_{dc} gleich der Maximalspannung Uₘₐₓ und die Betriebs- oder Sperrschichttemperatur T_{B} gleich der Minimaltemperatur.

Für einen Betriebspunkt 76, in welchem die Zwischenkreisspannung U_{dc} gleich dem Spannungsschwellwert Uₜₕᵣₑₛₕ und der Laststrom I_{c} gleich dem Stromschwellwert Iₜₕᵣₑₛₕ ist, ist die Betriebstemperatur T_{B} gleich dem Temperaturschwellwert Tₜₕᵣₑₛₕ. In diesem Ausführungsbeispiel erstreckt sich eine Bereichsgrenze oder Kennlinie Li von der Minimalspannung Uₘᵢₙ und dem Stromschwellwert Iₜₕᵣₑₛₕ bis zu dem Betriebspunkt 76. Die Kennlinie L₁ trennt hierbei den Betriebsbereich 70 von dem Betriebsbereich 68.

Für einen Betriebspunkt des Betriebsbereichs 68 wird ein Steuersignal P' mit der zweite Abschaltgeschwindigkeit A₂ erzeugt. Der Betriebsbereich 68 ist in dem Schritt 60 durch eine Kombination des Temperaturergebnisses Tᵣₑₛ und des Stromergebnisses Iᵣₑₛ definiert, in welcher einerseits die Betriebstemperatur T_{B} größer als der Temperaturschwellwert Tₜₕᵣₑₛₕ ist, und andererseits der Laststrom I_{c} größer als der Stromschwellwert Iₜₕᵣₑₛₕ sowie weiterhin die Zwischenkreisspannung U_{dc} kleiner als der Spannungsschwellwert Uₜₕᵣₑₛₕ ist.

Der Betriebsbereich 70, für welchen das Steuersignal P' auf die dritte Abschaltgeschwindigkeit A₃ eingestellt wird, ist in dem Schritt 60 ebenfalls als eine Kombination des Temperaturergebnisses Tᵣₑₛ und des Stromergebnisses Iᵣₑₛ hinterlegt. Für den Betriebsbereich 70 ist die Betriebstemperatur T_{B} größer als der Temperaturschwellwert Tₜₕᵣₑₛₕ und der Laststrom I_{c} kleiner als der Stromschwellwert Iₜₕᵣₑₛₕ sowie die Zwischenkreisspannung U_{dc} kleiner als der Spannungsschwellwert Uₜₕᵣₑₛₕ.

In dem Ausführungsbeispiel der FIG 4 erstreckt sich der Hauptbetriebsbereich 62 über die Betriebsbereiche 66 und 70, das bedeutet, dass in dem Hauptbetriebsbereich 62 eine Umschaltung von der ersten Abschaltgeschwindigkeit A₁ auf die dritte Abschaltgeschwindigkeit A₃ erfolgt. Dadurch werden die Effizienz und der Wirkungsgrad in dem Hauptbetriebsbereich 62 wesentlich verbessert, da somit (zumindest bereichsweise) eine Erhöhung der (Ab-)Schaltgeschwindigkeit möglich ist.

Das Ausführungsbeispiel der FIG 5 zeigt einen Arbeitsbereich in welchem die Bereichsgrenzen der Betriebsbereiche 66, 68, 70 zum Zwecke einer besonders hohen Effizienz des Stromrichters 8 eingestellt sind. In diesem Ausführungsbeispiel erstreckt sich die durch den Stromschwellwert Iₜₕᵣₑₛₕ definierte Kennlinie L₁ zwischen den Betriebsbereichen 68 und 70 im Wesentlichen über den vollständigen Spannungsbereich zwischen der Minimalspannung Uₘᵢₙ und der Maximalspannung Uₘₐₓ. Die Betriebsbereiche 68 und 70 werden lediglich für Betriebstemperaturen T_{B} größer oder gleich dem Temperaturschwellwert Tₜₕᵣₑₛₕ eingesetzt. Der Wert des Stromschwellwerts Iₜₕᵣₑₛₕ ist hierbei abhängig vom jeweiligen Wert der Zwischenkreisspannung U_{dc}. Der Verlauf der Kennlinie L₁ ist hierbei einerseits durch den Betriebspunkt 76 und andererseits durch die verwendeten Halbleiterschalter 22 bestimmt. In dem Ausführungsbeispiel weist der Stromschwellwert Iₜₕᵣₑₛₕ einen (monoton) abfallenden Verlauf auf, das bedeutet, dass der Stromschwellwert Iₜₕᵣₑₛₕ für die Minimalspannung Uₘᵢₙ einen höheren Stromwert des Laststroms I_{c} aufweist als für die Maximalspannung Uₘₐₓ.

In dem Ausführungsbeispiel der FIG 5 ist der Hauptbetriebsbereich 62 somit vollständig innerhalb des Betriebsbereichs 70 eingebettet. Mit anderen Worten werden für alle Betriebspunkte des Hauptbetriebsbereichs 62 Steuersignale P' mit der dritten Abschaltgeschwindigkeit A₃ erzeugt. Dadurch ist ein besonders effektiver Betrieb des Stromrichters 8 sichergestellt.

Der Betriebsbereich 66' ist hierbei in dem Schritt 60 durch eine Kombination hinterlegt, in welcher das Temperaturergebnis Tᵣₑₛ einer Betriebstemperatur T_{B} kleiner dem Temperaturschwellwert Tₜₕᵣₑₛₕ und in welcher das Spannungsergebnis Uᵣₑₛ einer Zwischenkreisspannung U_{dc} entspricht, welche größer dem Spannungsschwellwert Uₜₕᵣₑₛₕ ist. Hierbei ist eine zusätzliche Bereichsgrenze oder Kennlinie L₂ vorgesehen, welche im Wesentlichen parallel zu dem Stromschwellwert Iₜₕᵣₑₛₕ verläuft und somit die Betriebsbereiche 68 und 66' voneinander trennt.

Der Betriebsbereich 66' umfasst in diesem Ausführungsbeispiel vergleichsweise wenige Betriebspunkte, welche lediglich in einigen wenigen Betriebssituationen auftreten. Die Betriebsbereiche 68 und 70 umfassen - im Vergleich zu dem voranstehend beschriebenen Ausführungsbeispiel - jeweils eine größere Anzahl von Betriebspunkten, sodass die Halbleiterschalter 22 über weite Abschnitte des Arbeitsbereichs mit einer schnellen oder sehr schnellen Abschaltgeschwindigkeit A₂ beziehungsweise A₃ abgeschaltet werden.

In einer geeigneten Dimensionierung ist der Minimalstrom Iₘᵢₙ beispielsweise 0 A (Ampere), der Stromschwellwert Iₜₕᵣₑₛₕ beträgt etwa 400 A, und der Maximalstrom Iₘₐₓ ist auf etwa 650 A dimensioniert. Geeignete Spannungswerte der Zwischenkreisspannung U_{dc} sind hierbei beispielsweise 250 V für die Minimalspannung Uₘᵢₙ, 400 V für den Spannungsschwellwert Uₜₕᵣₑₛₕ, und 450 V für die maximal zulässige Zwischenkreisspannung Uₘₐₓ. Die Betriebstemperatur T_{B} weist vorzugsweise eine Minimaltemperatur Tₘᵢₙ von etwa -40 °C und einen Temperaturschwellwert Tₜₕᵣₑₛₕ von etwa 25 °C auf.

Die Kennlinie L₁ des Stromschwellwertes Iₜₕᵣₑₛₕ wird hierbei dadurch erzeugt, dass zunächst der (Abschalt-)Vorwiderstand R_{g3} der Ansteuerschaltung 30 zugeschaltet wird. Dadurch wird der Betriebspunkt 76 als Ausgangspunkt definiert. Die weiteren Punkte der Kennlinie L₁ sind in der Folge durch die maximal zulässige (Kollektor-Emitter-)Sperrspannung der Halbleiterschalter 22 definiert, welche mittels der Zwischenkreisspannung U_{dc} und der - durch die Induktivität des Zwischenkreises 10 bedingten - Abschaltspannung der Halbleiterschalter 22 bestimmbar sind.

Die Kennlinie L₂ wird in gleicher Art und Weise wie die Kennlinie L₁ erzeugt, wobei in der Ansteuerschaltung 30 jedoch der Vorwiderstand R_{g2} anstelle des Vorwiderstandes R_{g3} geschaltet wird. Dadurch wird der Betriebspunkt 72 als Ausgangspunkt der Kennlinie L₂ bestimmt. Durch die Kennlinie L₂ wird die erste Abschaltgeschwindigkeit A₁ abhängig vom Laststrom I_{c} und der Zwischenkreisspannung U_{dc} eingestellt, wenn die Betriebstemperatur T_{B} (z. B. 60 °C) größer als der Temperaturschwellwert Tₜₕᵣₑₛₕ (25 °C) ist. Dieser Fall tritt beispielsweise in einem Betriebspunkt (U_{dc} = 430 V, I_{c} = 500 A) auf, in welchem der Laststrom I_{c} größer als der Stromschwellwert (400 A) und die Zwischenkreisspannung größer als der Spannungsschwellwert (400 V) ist.

Solange die Betriebstemperatur T_{B} (z.B. -40 °C) kleiner als der Temperaturschwellwert (25 °C) ist, wird der Stromrichter 8 - unabhängig vom Betriebspunkt (U_{dc}, I_{c}) - mit der langsamen Abschaltgeschwindigkeit A₁ betrieben. Hierbei ist der Widerstandswert des Vorwiderstandes R_{g1} für ein betriebssicheres Schalten bei niedrigen Betriebstemperaturen T_{B} der Halbleiterschalter 22 geeignet dimensioniert.

Wenn die Betriebstemperatur T_{B} größer als der Temperaturschwellwert Tₜₕᵣₑₛₕ ist und sich der Betriebspunkt (U_{dc}, I_{c}) des Stromrichters 8 zwischen den Kennlinien L₁ und L₂ befindet, wird das Steuersignal P' mit der zweiten Abschaltgeschwindigkeit A₂ erzeugt.

Mit anderen Worten wird im Verfahrensschritt 58 zunächst das Temperaturergebnis Tᵣₑₛ ausgewertet. Wenn das Temperaturergebnis Tᵣₑₛ einem Betriebstemperatur T_{B} entspricht welche kleiner als der Temperaturschwellwert Tₜₕᵣₑₛₕ ist, wird unabhängig von dem Spannungsergebnis Uᵣₑₛ und dem Stromergebnis Iᵣₑₛ das Steuersignal P' mit der ersten Abschaltgeschwindigkeit A₁ erzeugt.

Wenn das Temperaturergebnis Tᵣₑₛ einem Betriebstemperatur T_{B} entspricht welche größer oder gleich dem Temperaturschwellwert Tₜₕᵣₑₛₕ ist, wird in Abhängigkeit des jeweiligen Betriebspunkts eine entsprechende Abschaltgeschwindigkeit ausgewählt. Befindet sich der durch das Spannungsergebnis Uᵣₑₛ und das Stromergebnis Iᵣₑₛ definierte Betriebspunkt oberhalb der Kennlinie L₂ wird das Steuersignal P' mit der ersten Abschaltgeschwindigkeit A₁ erzeugt (Betriebsbereich 66'). Befindet sich der Betriebspunkt zwischen den beiden Kennlinien L₁ und L₂, das bedeutet im Betriebsbereich 68, so wird die zweite Abschaltgeschwindigkeit A₂ eingestellt. Entsprechend wird die dritte Abschaltgeschwindigkeit A₃ für Betriebspunkte unterhalb der Kennlinie L₁ (Betriebsbereich 70) eingestellt.

Beispielsweise ist die Anzahl der unterschiedlichen Abschaltgeschwindigkeiten - und somit der Vorwiderstände - im Wesentlichen beliebig. Wesentlich ist, dass verfahrensgemäß stets eine möglichst optimale Abschaltgeschwindigkeit in Abhängigkeit des jeweiligen Betriebspunkts eingestellt wird.

## Patentansprüche

1. Verfahren zum Betreiben eines Stromrichters (8), insbesondere einer elektrischen Maschine (2), bei dem für den oder jeden Halbleiterschalter (22) des Stromrichters (8) ein Steuersignal (P') zur Einstellung einer Abschaltgeschwindigkeit (Aneu) erzeugt wird,
- wobei eine elektrische Zwischenkreisspannung (U_{dc}) eines Zwischenkreises (10) erfasst und mit einem Spannungsschwellwert (Uₜₕᵣₑₛₕ) verglichen wird,
- wobei eine Betriebstemperatur (T_{B}) des jeweiligen Halbleiterschalters (22) erfasst und mit einem Temperaturschwellwert (Tₜₕᵣₑₛₕ) verglichen wird,
- wobei ein mittels des jeweiligen Halbleiterschalters (22) geschalteter Laststrom (I_{c}) erfasst und mit einem Stromschwellwert (Iₜₕᵣₑₛₕ) verglichen wird,
- wobei das Steuersignal (P') zur Einstellung der Abschaltgeschwindigkeit (Aₙₑᵤ) in Abhängigkeit der Vergleiche erzeugt wird,
- wobei das Steuersignal (P') zur Einstellung der Abschaltgeschwindigkeit (Aₙₑᵤ) in Abhängigkeit der Vergleiche aus drei hinterlegten Abschaltgeschwindigkeiten (A₁, A₂, A₃) ausgewählt wird, wobei die erste Abschaltgeschwindigkeit (A₁) langsamer als die zweite Abschaltgeschwindigkeit (A₂) und die zweite Abschaltgeschwindigkeit (A₂) langsamer als die dritte Abschaltgeschwindigkeit (A₃) ist,
- wobei das Steuersignal (P') auf die erste Abschaltgeschwindigkeit (A₁) eingestellt wird, wenn die Betriebstemperatur (T_{B}) kleiner als der Temperaturschwellwert (Tₜₕᵣₑₛₕ) ist, und/oder wenn die Zwischenkreisspannung (U_{dc}) größer als der Spannungsschwellwert (Uₜₕᵣₑₛₕ) ist,
- wobei das Steuersignal (P') auf die zweite Abschaltgeschwindigkeit (A₂) eingestellt wird, wenn die Betriebstemperatur (T_{B}) größer als der Temperaturschwellwert (Tₜₕᵣₑₛₕ) ist, und wenn der Laststrom (I_{c}) größer als der Stromschwellwert (Iₜₕᵣₑₛₕ) ist, und
- wobei das Steuersignal (P') auf die dritte Abschaltgeschwindigkeit (A₃) eingestellt wird, wenn die Betriebstemperatur (T_{B}) größer als der Temperaturschwellwert (Tₜₕᵣₑₛₕ) ist, und wenn der Laststrom (I_{c}) kleiner als der Stromschwellwert (Iₜₕᵣₑₛₕ) ist.

2. Verfahren nach Anspruch 1,
**dadurch gekennzeichnet, dass** der Stromschwellwert (Iₜₕᵣₑₛₕ) in Abhängigkeit der Zwischenkreisspannung (U_{dc}) eingestellt wird.

3. Stromrichter (8), insbesondere einer elektrischen Maschine (2), mit einer Brückenschaltung (14) umfassend eine Anzahl von mittels Treiberschaltungen (20) angesteuerten Halbleiterschaltern (22), und mit einem signaltechnisch an die Treiberschaltungen (20) geführten Controller (18), welcher dazu vorgesehen und eingerichtet ist, ein Verfahren nach Anspruch 1 oder 2 durchzuführen.

4. Stromrichter (8) nach Anspruch 3,
**dadurch gekennzeichnet, dass** die Treiberschaltungen (20) eine der Anzahl der einstellbaren Abschaltgeschwindigkeiten (A₁, A₂, A₃) entsprechende Anzahl von elektrischen Vorwiderständen (R_{g1}, R_{g2}, R_{g3}) aufweisen.

5. Stromrichter (8) nach Anspruch 4,
**dadurch gekennzeichnet, dass** die Vorwiderstände (R_{g1}, R_{g2}, R_{g3}) der Treiberschaltungen (20) parallel zueinander geschaltet sind, und dass der Controller (18) eine jeweilige Ansteuerschaltung (30) der Treiberschaltungen (20) zum Umschalten zwischen den Vorwiderständen (R_{g1}, R_{g2}, R_{g3}) ansteuert.

6. Elektrische Maschine (2), insbesondere für ein elektrisch betriebenes Kraftfahrzeug, mit einem zwischen einem Energiespeicher (4) und einem Elektromotor (6) geschalteten Stromrichter (8) nach einem der Ansprüche 3 bis 5.

## Claims

1. Method for operating a converter (8), in particular an electrical machine (2), in which a control signal (P') for setting a switch-off speed (Aₙₑᵤ) is generated for the or each semiconductor switch (22) of the converter (8),
- wherein an intermediate circuit electrical voltage (U_{dc}) of an intermediate circuit (10) is detected and compared with a voltage threshold value (Uₜₕᵣₑₛₕ),
- wherein an operating temperature (T_{B}) of the respective semiconductor switch (22) is detected and compared with a temperature threshold (Tₜₕᵣₑₛₕ),
- wherein a load current (Iₑ) switched by means of the respective semiconductor switch (22) is detected and compared with a current threshold value (Iₜₕᵣₑₛₕ),
- wherein the control signal (P') for setting the switch-off speed (Aₙₑᵤ) is generated depending on the comparisons,
- wherein the control signal (P') for setting the switch-off speed (Aₙₑᵤ) is selected from three stored switch-off speeds (A₁, A₂, A₃) as a function of the comparisons, the first switch-off speed (A₁) being slower than the second switch-off speed (A₂) and the second switch-off speed (A₂) being slower than the third switch-off speed (A₃),
- wherein the control signal (P') is set to the first shutdown speed (A₁) when the operating temperature (T_{B}) is lower than the temperature threshold (Tₜₕᵣₑₛₕ) and/or when the DC link voltage (U_{dc}) is higher than the voltage threshold (Uthresh),
- wherein the control signal (P') is set to the second shutdown speed (A₂) when the operating temperature (T_{B}) is greater than the temperature threshold (Tₜₕᵣₑₛₕ) and when the load current (Iₑ) is greater than the current threshold (Iₜₕᵣₑₛₕ), and
- wherein the control signal (P') is set to the third cut-off speed (A₃) when the operating temperature (T_{B}) is greater than the temperature threshold (Tₜₕᵣₑₛₕ) and when the load current (Iₑ) is less than the current threshold (Iₜₕᵣₑₛₕ).

2. Method according to claim 1,
**characterized in that** the current threshold (Iₜₕᵣₑₛₕ) is set as a function of the DC link voltage (U_{dc}).

3. Converter (8), in particular of an electrical machine (2), having a bridge circuit (14) comprising a number of semiconductor switches (22) driven by means of driver circuits (20), and having a controller (18) which is connected in terms of signals to the driver circuits (20) and is provided and set up to carry out a method according to claim 1 or 2.

4. Converter (8) according to claim 3,
**characterized in that** the driver circuits (20) have a number of electrical series resistors (R_{g1}, R_{g2}, R_{g3}) corresponding to the number of adjustable switch-off speeds (A₁, A₂, A₃).

5. Converter (8) according to claim 4,
**characterized in that** the series resistors (R_{g1}, R_{g2}, R_{g3}) of the driver circuits (20) are connected in parallel with each other, and **in that** the controller (18) drives a respective drive circuit (30) of the driver circuits (20) for switching between the series resistors (R_{g1}, R_{g2}, R_{g3}).

6. An electric machine (2), in particular for an electrically powered motor vehicle, comprising a converter (8) connected between an energy storage device (4) and an electric motor (6) according to any one of claims 3 to 5.

## Revendications

1. Procédé permettant de faire fonctionner un convertisseur (8), en particulier une machine électrique (2), selon lequel un signal de commande (P') pour régler une vitesse de coupure (Aₙₑᵤ) est produit pour l'interrupteur à semi-conducteurs ou les interrupteurs à semi-conducteurs (22) du convertisseur (8),
- en ce qu'une tension de circuit intermédiaire électrique (U_{dc}) d'un circuit intermédiaire (10) est détectée et comparée à une valeur seuil de tension (Uthresh),
- en ce qu'une température de fonctionnement (TB) de l'interrupteur à semi-conducteurs (22) concerné est détectée et comparée à une valeur seuil de température (Tthresh),
- en ce qu'un courant de charge (I_{c}) commuté au moyen de l'interrupteur à semi-conducteurs (22) respectif est détecté et comparé à une valeur seuil de courant (Ithresh),
- en ce que le signal de commande (P') pour ajuster la vitesse de coupure (Aneu) est produit en fonction des résultats desdites comparaisons,
- en ce que le signal de commande (P') pour ajuster la vitesse de coupure (Aneu) est sélectionné en fonction des comparaisons des trois vitesses de coupure (A1, A2, A3) enregistrées, en ce que la première vitesse de coupure (A1) est plus lente que la deuxième vitesse de coupure (A2) et la deuxième vitesse de coupure (A2) est plus lente que la troisième vitesse de coupure (A3),
- en ce que le signal de commande (P') est ajusté sur la première vitesse de coupure (A1) lorsque la température de fonctionnement (TB) est inférieure à la valeur seuil de température (Tthresh), et/ou lorsque la tension de circuit intermédiaire (Udc) est supérieure à la valeur seuil de tension (Uthresh),
- en ce que le signal de commande (P') est ajusté sur la deuxième vitesse de coupure (A2) lorsque la température de fonctionnement (TB) est supérieure à la valeur seuil de température (Tthresh), et lorsque le courant de charge (I_{c}) est supérieur à la valeur seuil de courant (Ithresh), et
- en ce que le signal de commande (P') est ajusté sur la troisième vitesse de coupure (A3) lorsque la température de fonctionnement (TB) est supérieure à la valeur seuil de température (Tthresh), et lorsque le courant de charge (I_{c}) est inférieur à la valeur seuil de courant (Ithresh).

2. Procédé selon la revendication 1, **caractérisé en ce que** la valeur seuil de courant (Iₜₕᵣₑₛₕ) est réglée en fonction de la tension de circuit intermédiaire (U_{dc}).

3. Convertisseur (8), en particulier une machine électrique (2), avec un montage en pont (14) comprenant un nombre d'interrupteurs à semi-conducteurs (22) commandés au moyen de circuits d'attaque (20), et avec un contrôleur (18) guidé par des signaux aux circuits d'attaque (20), ledit contrôleur étant prévu et conçu pour effectuer un procédé selon la revendication 1 ou 2.

4. Convertisseur (8) selon la revendication 3, **caractérisé en ce que** les circuits d'attaque (20) comportent un nombre de résistances série (R_{g1}, R_{g2}, R_{g3}) électriques correspondant au nombre des vitesses de coupure (A₁, A₂, A₃) réglables.

5. Convertisseur (8) selon la revendication 4, **caractérisé en ce que** les résistances série (R_{g1}, R_{g2}, R_{g3}) sont montées en parallèle par rapport aux circuits d'attaque (20), et que le contrôleur (18) commande un circuit de commande (30) respectif des circuits d'attaque (20) pour commuter entre les résistances série (R_{g1}, R_{g2}, R_{g3}).

6. Machine électrique (2), en particulier pour un véhicule à entraînement électrique, avec un convertisseur (8) monté entre un accumulateur d'énergie (4) et un moteur électrique (6) selon l'une des revendications 3 à 5.
